# EUROPÄISCHE PATENTSCHRIFT

(11) **EP 2 439 763 B1**
(45) Veröffentlichungstag und Bekanntmachung des Hinweises auf die Patenterteilung: **03.06.2020**
(21) Anmeldenummer: 11175218.4
(22) Anmeldetag: 25.07.2011
(51) Int. Cl.: H01J 37/34

(54) **Magnetron-Vorrichtung und Verfahren zum gepulsten Betreiben einer Magnetron-Vorrichtung**
Magnetron device and method for pulsed operation of a magnetron device
Dispositif de magnétron et procédé de fonctionnement pulsé d'un dispositif à magnétron

(30) Priorität: 08.10.2010 DE 102010047963
(43) Veröffentlichungstag der Anmeldung: 11.04.2012
(73) Patentinhaber: Fraunhofer-Gesellschaft zur Förderung der angewandten Forschung, 80686 München (DE)
(72) Erfinder: Bartzsch, Hagen, 01309 Dresden (DE); Labitzke, Rainer, 01189 Dresden (DE); Frach, Peter, 01454 Radeberg (DE); Gittner, Matthias, 01307 Dresden (DE)

(56) Entgegenhaltungen:
- WO-A1-2008/067969
- DE-A1- 19 506 513
- DE-A1- 19 651 811
- DE-A1- 19 830 404
- DE-A1-102007 011 230
- US-A- 5 917 286
- FRACH P ET AL: "Electrically insulating Al2O3 and SiO2 films for sensor and photovoltaic applications deposited by reactive pulse magnetron sputtering, hollow cathode arc activated deposition and magnetron-PECVD", SURFACE AND COATINGS TECHNOLOGY, ELSEVIER, AMSTERDAM, NL, Bd. 202, Nr. 22-23, 30. August 2008 (2008-08-30), Seiten 5680-5683, XP025875607, ISSN: 0257-8972, DOI: 10.1016/J.SURFCOAT.2008.06.043 [gefunden am 2008-06-10]
- H BARTZSCH ET AL: "Anode effects on energetic particle bombardment of the substrate in pulsed magnetron sputtering", SURFACE AND COATINGS TECHNOLOGY, Bd. 132, Nr. 2-3, 1. Oktober 2000 (2000-10-01), Seiten 244-250, XP055211058, ISSN: 0257-8972, DOI: 10.1016/S0257-8972(00)00861-6

## Beschreibung

Die Erfindung betrifft eine Magnetron-Vorrichtung und ein Verfahren zum Betreiben einer Magnetron-Vorrichtung, bei der die elektrische Energie in gepulster Form zugeführt wird. Dabei kann die Magnetron-Vorrichtung sowohl als Teilchenquelle zur Schichtabscheidung mittels Magnetronsputtern, d. h. einem Prozess der physikalischen Dampfabscheidung (PVD), als auch als Plasmaquelle in einem Prozess der plasmaaktivierten chemischen Dampfabscheidung (PECVD) verwendet werden.

### Stand der Technik

Beim Abscheiden isolierender Schichten mittels reaktiven Magnetronsputterns eines Metalltargets in einem Gemisch aus Inertgas und Reaktivgas hat sich die gepulste Energieeinspeisung im Frequenzbereich zwischen 10 und 350 kHz durchgesetzt. Grund dafür ist eine verbesserte Prozessstabilität bei gepulster Energieeinspeisung im Vergleich zur DC-Energieeinspeisung. In den Pulspausen des gepulsten Prozesses können Ladungsträger aus dem Plasma mit Ladungsträgern, die sich auf isolierenden Schichten angesammelt haben, rekombinieren. Dadurch kann die für den Beschichtungsvorgang schädliche Ausbildung von Bogenentladungen verhindert werden. Somit wird durch die gepulste Energieeinspeisung ein langzeitstabiler Beschichtungsprozess gewährleistet. Weiterhin werden mit gepulster Energie gespeiste Magnetronquellen auch als Plasmaquellen für die plasmaaktivierte chemische Dampfabscheidung mit ähnlichen Vorteilen hinsichtlich der Stabilität genutzt.
Es haben sich zwei prinzipiell unterschiedliche Hauptformen der gepulsten Energieeinspeisung beim Magnetronsputtern etabliert, die auch als unipolarer und bipolarer Pulsmode bezeichnet werden. Im unipolaren Pulsmode wird eine gepulste Gleichspannung zwischen dem Target einer Magnetron-Sputterquelle und einer separaten Elektrode, dem Substrat oder der Rezipientenmasse angelegt. In DE 37 00 633 C2 ist solch eine Variante der Energieeinspeisung allgemein für PVD-Prozesse beschrieben. Dabei wirkt das Target als Katode der Gasentladung und die Rezipientenmasse, das Substrat oder die separate Elektrode als Anode.

Im bipolaren Pulsmode wird zwischen zwei elektrisch voneinander isolierten Targets einer Doppel-Magnetron-Anordnung eine elektrische Spannung alternierender Polarität angelegt. Dabei wirken diese Targets wechselweise als Anode und Katode der als Magnetronentladung ausgebildeten Gasentladung. Eine separate Elektrode als Anode wird daher nicht benötigt. In DD 252 205 A1 und DE 38 02 852 A1 wird das allgemeine Prinzip dieser bipolaren Energieeinspeisung beschrieben. In DE 44 38 463 C1 ist eine vielfach verwendete Ausführungsform für die bipolare Pulseinspeisung angegeben.

In US 5 917 286 A sind gepulst betriebene Gleichspannungsquellen beschrieben, mittels denen mindestens drei innerhalb einer Vakuumkammer angeordnete Elektroden derart angesteuert werden können, dass an jeder der drei Elektroden immer ein Spannungspol der Gleichspannungsquelle durchgeschaltet ist, wobei die Polarität an jeder der Elektroden umgeschaltet werden kann, wodurch das Entstehen von Arcs unterdrückt werden kann.

DE 198 30 404 A1 beischreibt eine Ausführungsform mit bipolarer Pulseinspeisung, bei der mittels einer Zusatzelektrode das Plasmapotential gegenüber dem Potential eines zu beschichtenden Substrates erhöht und somit auch die auf das Substrat einwirkende Ionenenergie erhöht werden kann. Nachteilig wirkt sich hierbei aus, dass diese Ausführungsform nur bei elektrisch leitfähigen Substraten anwendbar ist.

Auch aus DE 196 51 811 A1 sind Ausführungsformen mit bipolarer Pulseinspeisung bekannt, bei denen die Vakuumkammerwand zeitweise als Zusatzelektrode geschaltet und dadurch die Ionenenergie erhöht werden kann. Mittels solch einer Vorrichtung lässt sich die Beschleunigung von Ionen in einem beschränkten Umfang variieren.

Bekannt sind ebenfalls Magnetron-Sputtereinrichtungen, die aufgrund von zwei elektrisch isolierten Targets und weiteren elektrisch isolierten Zusatzelektroden wahlweise einen unipolar oder bipolar gepulsten Betrieb ermöglichen (DE 195 06 513 A1).

Ferner sind spezielle Formen der gepulsten Energieeinspeisung bekannt, die sowohl Merkmale des unipolaren als auch des bipolaren Betriebes aufweisen. In WO 2009/040406 A2 ist beispielsweise das sogenannte redundante Anoden-Sputtern beschrieben. Dabei werden neben dem auf Katodenpotenzial liegenden Target zwei Elektroden abwechselnd als Anode und Katode betrieben, wobei die jeweils auf Katodenpotenzial liegende Elektrode in dieser Phase frei gesputtert wird und dadurch in der Anodenphase eine dauerhaft wirksame Anode darstellt.

In DE 10 2007 011 230 A1 werden die elektrischen Potentiale einer Puls-Stromversorgung mit einer DC-Stromversorgung überlagert, um beispielsweise die Abscheiderate bei sogenannten HIPIMS-Prozessen zu erhöhen oder um sich an bestimmte Targetmaterialien anzupassen. Die in WO 2008/067969 A1 offenbarten Ausführungsformen weisen sogar mehrere Pulseinheiten und DC-Stromversorgungen auf, mit dem Ziel, eine hohe Plasmadichte in substratnahen Bereichen beim Beschichten von 3D-Bauteilen zu ermöglichen.
Beim Energieeintrag im sogenannten Puls-Paket-Modus (DE 197 02 187 A1) werden Pakete unipolarer Pulse zwischen zwei Targets einer Doppel-Magnetron-Anordnung gelegt. Zwischen zwei aufeinanderfolgenden Paketen erfolgt jeweils ein Polaritätswechsel.

In "Electrically insulating Al203 and Si02 films for sensor and photovoltaic applications deposited by reactive pulse magnetron sputtering, hollow cathode arc activated deposition and magnetron-PECVD", Frach, P. et al:, Surface and Coating Technology, Vol. 202, Nr. 22-23, 2008, p. 5680 - 5683, sind Vorrichtungen offenbart, mit denen elektrisch isolierende Schichten im unipolar gepulsten, bipolar gepulsten oder Hochfrequenz-Modus abgeschieden werden können und es ist dargelegt, wie sich die unterschiedlichen Abscheide-Modi auf die Schichteigenschaften auswirken.

Die sogenannte asymmetrisch bipolare Energieeinspeisung (DE 41 27 317 A1) beschreibt eine im Prinzip unipolar gepulste Einrichtung mit einem Target, wobei dem eigentlichen, der Schichtabscheidung dienenden, negativen Spannungspuls auf dem Target (der Katode) ein sehr kurzer positiver Puls vorangestellt ist, der die Rekombination von Ladungsträgern bewirken und damit die Stabilität der Entladung noch weiter verbessern soll.

Die Erfahrung zeigt, dass zwischen unipolarem und bipolarem Pulsmode wesentliche Unterschiede hinsichtlich der Plasmadichte, unmittelbar vor einem zu beschichtenden Substrat und des daraus resultierenden Beschusses der aufwachsenden Schicht mit energiereichen Teilchen, vorliegen. Ergebnisse diesbezüglicher Untersuchungen sind beispielsweise in "Anode effects on energetic particle bombardment of the substrate in pulsed magnetron sputtering" Bartzsch, H. et al:, Surface and Coatings Technology, Vol. 132, Nr. 2-3, 2000, p. 244 - 250, offenbart. Im unipolaren Pulsmode liegen erfahrungsgemäß eine niedrige Plasmadichte und ein schonender Substratbeschuss vor, wie es beispielsweise beim Beschichten temperaturempfindlicher Substrate erwünscht ist. Im bipolaren Pulsmode liegt dagegen erfahrungsgemäß ein sehr starker Substratbeschuss vor, der zum Erzeugen sehr dichter Schichten vorteilhaft genutzt werden kann. Die Unterschiede in der Plasmadichte vor der Oberfläche eines zu beschichtenden Substrates und damit in der Ionenstromdichte auf das Substrat können dabei bei der gleichen Sputtereinrichtung, sofern diese für beide Pulsmodi geeignet ist, größer als Faktor 10 sein [Surface and Coatings Technology 132 (2000) 244 - 250]. Physikalische Ursache für diese beträchtlichen Unterschiede ist die Nutzung eines Magnetrontargets als Anode im bipolaren Betrieb. Das dort anliegende Magnetfeld verdrängt energiereiche Elektronen aus targetnahen Bereichen in substratnahe Bereiche und führt zu der hohen Plasmadichte vor dem Substrat.

Die Möglichkeit, eine Anordnung von mindestens zwei Magnetron-Sputterquellen wahlweise im unipolaren oder bipolaren Pulsmode zu betreiben, erlaubt es, durch Wahl des Pulsmodes für viele Anwendungen eine geeignete Intensität des energetischen Substratbeschusses einzustellen. Ist jedoch eine feinere Dosierung des energetischen Substratbeschusses zwischen den beiden Pulsmodi erforderlich, reicht diese Wahlmöglichkeit nicht mehr aus.

Die oben beschriebenen Abwandlungen bzw. Kombinationen von unipolaren und bipolaren Energieeinspeisungen stehen hinsichtlich der Intensität des energetischen Substratbeschusses jeweils einem der beiden Pulsmodi nahe. So liegt bei dem redundanten Anoden-Sputtern und der asymmetrisch bipolaren Energieeinspeisung ein mit der unipolaren Energieeinspeisung vergleichbarer Substratbeschuss vor, während bei der Puls-Paket-Energieeinspeisung ein mit der bipolaren Energieeinspeisung vergleichbarer Substratbeschuss vorliegt. Eine Einstellmöglichkeit der Intensität des energetischen Substratbeschusses über einen größeren Bereich ist für keine der genannten Techniken gegeben.

Eine weitere Möglichkeit, den Substratbeschuss mit energiereichen Teilchen zu erhöhen und zu beeinflussen, ist das Anlegen einer Biasspannung an das Substrat. Dadurch kann die Energie der auf das Substrat treffenden Ionen definiert erhöht werden. Als DC- oder Puls-Bias ist eine solche Biasspannung nur für leitfähige Substrate geeignet. Mittels HF-Energieeinspeisung kann auch für isolierende Substrate eine Biasspannung auf der Substratoberfläche erzeugt werden. Nachteilig bei allen Biasverfahren, insbesondere beim HF-Bias, ist der erhöhte apparative Aufwand. Außerdem sind in Kombination mit Substratbias andere Möglichkeiten der Beeinflussung des Schichtwachstums auf dem Substrat wie Substratbewegung, Substratheizung oder Substratkühlung häufig nicht mehr oder nur mit hohem technischen Aufwand möglich. Ein weiterer Nachteil besteht darin, dass durch eine Biasspannung zwar die Energie der auf das Substrat treffenden Ionen beeinflusst werden kann, nicht aber oder nur in sehr geringem Umfang deren Stromdichte. Eine zu hohe Energie der Ionen kann aber zur Schädigung der aufwachsenden Schicht oder des Substrates führen. Aus den genannten Gründen sind DC-, Puls- und HF-Substratbias nicht in allen Fällen geeignet, einen einstellbaren Beschuss des Substrates mit energetischen Teilchen zu realisieren.

In DE 196 51 811 A1 ist eine Einrichtung zur bipolaren Energieeinspeisung beschrieben, bei der durch eine zusätzliche, einstellbare, gepulste Spannung zusätzlich Ionen zum Substrat beschleunigt werden können. Damit können vergleichbare Effekte wie mit Substratbias erzielt werden. Nachteilig an dieser Anordnung ist, dass wie beim Substratbias in erster Linie die Energie der Ionen und nur in geringerem Maße deren Stromdichte beeinflusst werden können. Außerdem kann die Intensität des Substratbeschusses nur über das bereits hohe Niveau des bipolaren Modes hinaus erhöht werden.

### Aufgabenstellung

Der Erfindung liegt daher das technische Problem zugrunde, eine Magnetron-Vorrichtung und ein Verfahren zum gepulsten Betreiben einer Magnetron-Vorrichtung zu schaffen, mittels denen die Nachteile aus dem Stand der Technik überwunden werden können. Insbesondere soll bei einer Substratbeschichtung mittels einer mit gepulster Energie gespeisten Doppel-Magnetron-Einrichtung eine Einstellmöglichkeit für die Intensität des Beschusses der aufwachsenden Schicht mit energiereichen Teilchen gefunden werden. Mittels Vorrichtung und Verfahren soll es unabhängig von der Substratart möglich sein, die Stromdichte der auf das Substrat auftreffenden Teilchen zu variieren. Ferner sollen sich Vorrichtung und Verfahren mit geringem technischen Aufwand realisieren lassen.

Die Lösung des technischen Problems ergibt sich durch die Gegenstände mit den Merkmalen der Patentansprüche 1 und 9. Weitere vorteilhafte Ausgestaltungen der Erfindung ergeben sich aus den abhängigen Patentansprüchen.

Ausgangspunkt der erfindungsgemäßen Lösung ist eine Magnetron-Vorrichtung mit bipolar gepulster Energieeinspeisung, welche demzufolge mindestens zwei elektrisch voneinander isolierte Targets umfasst, zwischen denen mittels mindestens einer Stromversorgungseinrichtung eine elektrische Wechselspannung angelegt wird, so dass die beiden Targets abwechselnd als Katode und Anode einer Gasentladung zwischen den beiden Targets fungieren. Der Phasenwechsel an den beiden Targets wird üblicherweise periodisch mit einer ersten Frequenz vollzogen. Alternativ könnte der Phasenwechsel aber auch nichtperiodisch erfolgen.

Erfindungsgemäß wird dieser Aufbau durch mindestens eine zusätzliche Elektrode ergänzt, die mittels eines Schalters zeitweise und wiederholt als Anode einer Gasentladung zwischen der zusätzlichen Elektrode und dem jeweils als Katode fungierenden Target geschaltet wird. Damit wird eine neue Mischform aus unipolar und bipolar gepulstem Betrieb eines Magnetrons geschaffen. Beim Zuschalten der zusätzlichen Elektrode bildet sich eine Magnetronentladung zwischen der zusätzlichen Elektrode und jeweils dem Target aus, das als Katode der Magnetronentladung zwischen den beiden Targets geschaltet ist. Aufgrund des Sachverhalts, dass die zusätzliche Elektrode nicht so stark vom Magnetronmagnetfeld abgeschirmt ist, wie es bei Magnetrontargets der Fall ist, bewegen sich die frei beweglichen Elektronen in den Phasen, in denen die zusätzliche Elektrode als Anode geschaltet ist, bevorzugt zur zusätzlichen Elektrode hin, wodurch sich in diesen Phasen vorwiegend eine Magnetronentladung zwischen der zusätzlichen Elektrode und dem jeweiligen Katoden-Target ausbildet. Der Schalter zum Zuschalten der zusätzlichen Elektrode kann beispielsweise als Halbleiterschalter ausgebildet sein.

Die zusätzliche Elektrode bei einer erfindungsgemäßen Vorrichtung stellt in der Regel eine separate, elektrisch isoliert aufgebaute Elektrode im Plasma dar. Besonders günstig ist es, diese so "versteckt" bzw. abgeschirmt anzuordnen, dass sie nicht direkt mit Reaktionsprodukten beschichtet werden kann und so dauerhaft elektrisch leitfähig bleibt. Im einfachsten Fall kann auch die Rezipientenmasse als Zusatzelektrode geschaltet werden. Alternativ können aber auch mehrere zusätzliche Elektroden als zusätzliche Anoden geschaltet werden. Durch eine entsprechende Anordnung der zusätzlichen Anoden innerhalb einer Vakuumkammer kann dann gezielt Einfluss auf die Form der sich innerhalb der Vakuumkammer ausbildenden Plasmawolke genommen werden.

Eine erfindungsgemäße Vorrichtung kann so aufgebaut sein, dass diese eine zusätzliche Elektrode aufweist, die nur einem Magnetrontarget zugeordnet ist, d. h. diese eine Zusatzelektrode wird nur in den Zeitphasen als Anode zugeschaltet, wenn das zugehörige Magnetrontarget als Anode geschaltet ist. Bei einer weiteren Ausgestaltung kann auf diese Weise auch jedem Magnetrontarget eine separate zusätzliche Elektrode zugeordnet sein. Alternativ besteht aber auch die Möglichkeit, eine zusätzliche Elektrode beiden Magnetrontargets bzw. mehreren Magnetrontargets zuzuordnen. Dies hat den Vorteil, dass die eine zusätzliche Elektrode während der Zeitspanne mehrerer Phasenwechsel durchgängig als Anode einer Magnetronentladung zugeschaltet bleiben kann. In diesen Zeitphasen bleibt dann die zusätzliche Elektrode ständig als Anode geschaltet, wohingegen die Katodenseite der Gasentladung zwischen den Targets hin und her wechselt.

Das zeitweise Zuschalten der zusätzlichen Elektrode als Anode kann periodisch mit einer zweiten Frequenz oder alternativ auch nichtperiodisch erfolgen. Bei einer Ausführungsform wird die zusätzliche Elektrode als zusätzliche Anode der Magnetronentladung geschaltet. Wie vorhergehend bereits beschrieben wurde, bildet sich in diesem Fall automatisch eine Magnetronentladung zwischen der zusätzlichen Elektrode und dem jeweiligen Katoden-Target aus. Alternativ kann aber auch in den Phasen, in denen die zusätzliche Elektrode als Anode geschaltet ist, jeweils das als Anode fungierende Target von der Stromversorgung getrennt werden, so dass in diesen Zeitphasen nur die zusätzliche Elektrode als Anode der Magnetronentladung fungiert.

Der Anteil der Zeit, innerhalb der die zusätzliche Elektrode als Anode geschaltet ist, kann zwischen 0 % und 100 % liegen und wird nachfolgend als Tastverhältnis bezeichnet.

Ein Tastverhältnis von 0 %, was dem Fall entspricht, dass die zusätzliche Elektrode überhaupt nicht als Anode zugeschaltet wird, entspräche dem herkömmlichen bipolaren Betrieb mit einer sehr hohen Plasmadichte vor dem Substrat, welches beispielsweise mittels des Magnetrons beschichtet werden soll. Bei einem Tastverhältnis von 100 % wäre die zusätzliche Elektrode ständig als Anode zugeschaltet, was dem herkömmlichen unipolaren Betrieb mit einer niedrigen Plasmadichte vor dem Substrat sehr nahe kommt, weil beim Zuschalten einer zusätzlichen, nicht vom Magnetronmagnetfeld abgeschirmten Elektrode als Anode, der Entladungsstrom nahezu vollständig über die zusätzliche Anode fließt. Die Entladung zwischen den beiden Targets ist in diesem Fall somit vernachlässigbar. Durch eine geeignete Festlegung des Tastverhältnisses zwischen 0 % und 100 % können somit die zwischen dem unipolar und dem bipolar gepulsten Betrieb liegenden Werte der Plasmadichte und eine entsprechende Intensität des energetischen Substratbeschusses beliebig eingestellt und auch während des Betriebes verändert werden.

Prinzipiell ist es denkbar, dass die Dauer des Zuschaltens der Zusatzelektrode als Anode kleiner gewählt wird als die Puls-Ein-Zeit der bipolar gepulsten Energieeinspeisung, die typischerweise 2 µs bis 100 µs beträgt. Allerdings besteht dann die Gefahr, dass die Plasma-Elektronen dem schnellen Elektrodenwechsel nicht mehr folgen können und dadurch die Entladung verlischt oder sich die Zündbedingungen verschlechtern. Daher ist es vorteilhaft, wenn die Zuschaltdauer der Zusatzelektrode als Anode länger ist als die Periodendauer der gepulsten Energieeinspeisung. Die zweite Frequenz wird somit bei diesen Ausführungsformen kleiner eingestellt als die erste Frequenz. In diesem Fall bildet sich in den Zeitphasen, in denen die zusätzliche Elektrode als Anode geschaltet ist, eine Gasentladung aus, bei der die zusätzliche Elektrode als Anode fungiert und bei der die Katode abwechselnd von den beiden Targets gebildet wird, d. h. die Katodenseite der Entladung "springt" zwischen den beiden Targets hin und her und zwar so lange, bis die Zusatzelektrode wieder abgeschaltet wird. Dann vollzieht sich die Magnetronentladung wieder wie beim bipolaren Magnetronbetrieb zwischen den beiden Targets, bis die Zusatzelektrode für das nächste Intervall zugeschaltet wird.

Umsetzbar ist auch, dass die Zuschaltdauer der Zusatzelektrode als Anode im Bereich bis hin zu einigen Sekunden eingestellt wird. Daraus ergibt sich eine Möglichkeit, bei der die abgeschiedene Schicht hinsichtlich ihrer Eigenschaften nicht mehr homogen in Wachstumsrichtung ist. Das kann gezielt für das Abscheiden von Multilayer- oder alternierenden Gradientenschichten genutzt werden.

Für das Abscheiden von in Wachstumsrichtung homogenen Schichten ist es hingegen vorteilhaft, wenn die Dauer des Zuschaltens der Zusatzelektrode als Anode kürzer als die Zeit zum Abscheiden einer Monolage der Schicht ist, die beim Puls-Sputtern typischerweise zwischen 10 ms und 500 ms eingestellt ist. Aus diesen Überlegungen ergibt sich eine sinnvolle Periodendauer für das Zu- und Wegschalten einer Zusatzelektrode als Anode im Bereich zwischen 2 µs und 500 ms. Das entspricht einer Zuschaltfrequenz der Zusatzelektrode im Bereich von 500 kHz bis 2 Hz.

Das Schalten eines Schalters bei Stromfluss, d. h. unter Last, stellt wesentlich höhere Anforderungen an die Spannungsfestigkeit des Schalters als das Schalten im lastfreien Zustand. Daher ist es vorteilhaft, das Schalten der Zusatzelektrode als Anode mit dem Polaritätswechsel der gepulsten Stromversorgung derart zu synchronisieren, dass ein Schaltvorgang für die zusätzliche Elektrode dann erfolgt, wenn die Ausgangsspannung der gepulsten Stromversorgung 0 V oder zumindest nahe 0 V ist. Der Begriff "nahe 0 V" bezeichnet elektrische Spannungen kleiner als 50 V. Derartig geringe elektrische Spannungen werden beispielsweise erzielt, wenn ein Polaritätswechsel an der Stromversorgungseinrichtung vollzogen wird. Bei einer Ausführungsform erfolgt daher das Zu- und/oder Wegschalten der zusätzlichen Elektrode zu Zeitpunkten, bei denen der Polaritätswechsel an den Targets erfolgt. Alternativ kann zum Optimieren der Zündbedingungen das Zu- und/oder Wegschalten der zusätzlichen Elektrode mit einer zeitlichen Verzögerung zum Polaritätswechsel der Targets erfolgen.

Unter Umständen kann es wünschenswert sein, den Beschuss der aufwachsenden Schicht mit energiereichen Teilchen während des Schichtwachstums zu verändern. So kann beispielsweise ein verstärkter energetischer Substratbeschuss zu Beginn des Schichtwachstums genutzt werden, um die Bildung einer kristallinen Phase zu initiieren. Im weiteren Verlauf des Schichtwachstums kann der Beschuss dann reduziert werden, um eine thermische Schädigung des Substrates zu verhindern. Umgekehrt kann es erforderlich sein, zu Beginn des Schichtwachstums den Substratbeschuss so stark wie möglich zu reduzieren, um darunterliegende sensitive Schichten nicht zu schädigen und danach den Substratbeschuss zu verstärken, um hinreichend dichte Schichtbereiche zu erzeugen. Eine solche Variation des energetischen Substratbeschusses während des Schichtwachstums kann mit der erfindungsgemäßen Einrichtung erreicht werden, indem das Tastverhältnis der Anodenzuschaltung während einer Beschichtung verändert wird.

### Ausführungsbeispiel

Die Erfindung wird nachfolgend anhand von Ausführungsbeispielen näher erläutert.
Die Fig. zeigen:
- Fig. 1: eine schematische Darstellung einer erfindungsgemäßen Vorrichtung;
- Fig. 2: eine schematische Darstellung einer alternativen erfindungsgemäßen Vorrichtung;
- Fig. 3: eine graphische Darstellung der Elektronendichte im Plasma in Abhängigkeit vom Tastverhältnis;
- Fig. 4: eine graphische Darstellung der mechanischen Schichtspannung in Abhängigkeit vom Tastverhältnis.

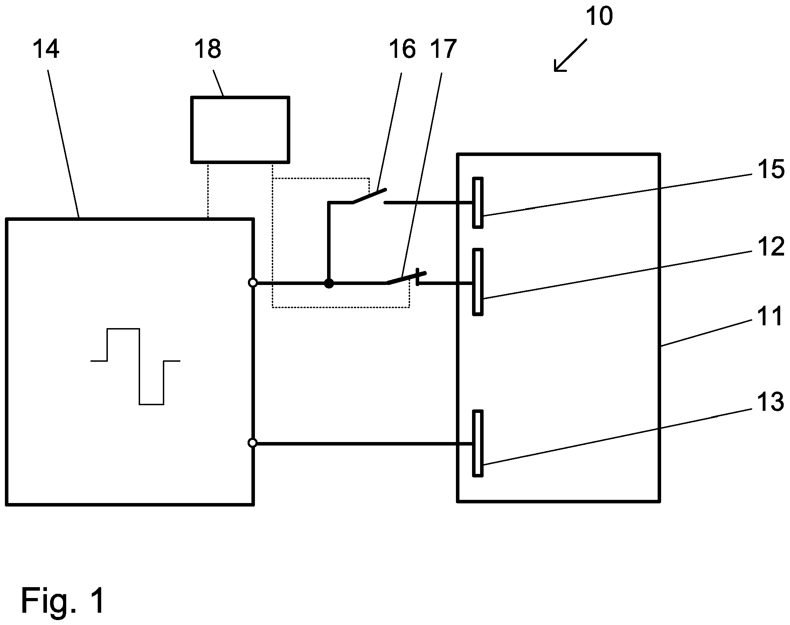

In Fig. 1 ist eine erfindungsgemäße Vorrichtung 10 schematisch dargestellt, die auch zum Ausführen des erfindungsgemäßen Verfahrens geeignet ist. Vorrichtung 10 umfasst eine Vakuumkammer 11, in der sich eine Doppelmagnetron-Einrichtung befindet, die zwei elektrisch voneinander isolierte Targets 12 und 13 aufweist. Mittels dieser Doppelmagnetron-Einrichtung kann beispielsweise innerhalb der Vakuumkammer 11 auf einem Substrat eine Schicht mittels eines PVD- oder PECVD-Prozesses abgeschieden werden. Die beiden Targets 12, 13 sind elektrisch jeweils mit einem Pol einer Stromversorgungseinrichung 14 verbunden, welche eine Wechselspannung zwischen den beiden Targets 12, 13 erzeugt. Die Magnetroneinrichtung wird somit bipolar betrieben, d. h. die beiden Targets 12, 13 werden periodisch abwechselnd als Katode und Anode einer Magnetronentladung geschaltet, die zwischen den beiden Targets 12, 13 brennt.

Erfindungsgemäß befindet sich auch noch eine zusätzliche Elektrode 15 innerhalb der Vakuumkammer 11. Die zusätzliche Elektrode 15 ist über einen Schalter 16 elektrisch an den Pol der Stromversorgungseinrichtung 14 angeschlossen, mit dem auch Target 12 über einen Schalter 17 elektrisch verbunden ist. Beide Schalter 16 und 17 können separat voneinander mittels einer Steuereinrichtung 18 geöffnet und geschlossen werden.

Für den reinen bipolaren Betrieb der Vorrichtung 10 bleibt der Schalter 17 ständig geschlossen und der Schalter 16 ständig geöffnet. Erfindungsgemäß kann mittels der Steuereinrichtung 18 in den Zeitphasen, in denen das Target 12 als Anode geschaltet ist, der Schalter 16 einmal oder auch mehrmals geschlossen und geöffnet werden. Dann fungiert die zusätzliche Elektrode 15 in den Zeitphasen, in denen Schalter 16 geschlossen ist, als zusätzliche Anode für eine Magnetronentladung zwischen dem katodischen Target 13 und der zusätzlichen Elektrode 15. Wie vorhergehend schon erläutert wurde, bilden sich bei einer Magnetronentladung mit einer nicht magnetisch abgeschirmten Anode andere Plasmaverhältnisse aus als bei einem anodisch geschalteten Target, das vom Magnetronmagnetfeld abgeschirmt ist. In Abhängigkeit davon, wie oft der Schalter 16 innerhalb einer anodischen Phase des Targets 12 geschlossen wird und/oder wie lange insgesamt der Schalter 16 innerhalb einer solchen Phase geschlossen bleibt, können somit Plasmaparameter innerhalb der Vakuumkammer 11 verändert werden.

Es besteht auch die Möglichkeit den Schalter 17 innerhalb der katodischen Phase des Targets 13 einmal oder mehrmals zu öffnen. Während der Zeitdauer des geöffneten Schalters 17 fungiert dann die zusätzliche Elektrode 15 als alleinige Anode der Magnetronentladung. Es ist jedoch darauf zu achten, dass während der katodischen Phasen des Targets 13 immer mindestens einer der Schalter 16, 17 geschlossen ist, damit zu jeder Zeit mindestens eine Anode für eine Magnetronentladung zum katodischen Target 13 zur Verfügung steht.

Der Vollständigkeit halber sei erwähnt, dass während der anodischen Phasen des Targets 13 der Schalter 17 durchgängig geschlossen bleibt und der Schalter 16 durchgängig geöffnet bleibt, so dass in diesen Phasen nur das Target 12 als Katode fungiert. Die zusätzliche Elektrode bei einer erfindungsgemäßen Vorrichtung im Allgemeinen und die Elektrode 15 aus Fig. 1 im Speziellen übernimmt zu keiner Zeit eine Katodenfunktion.

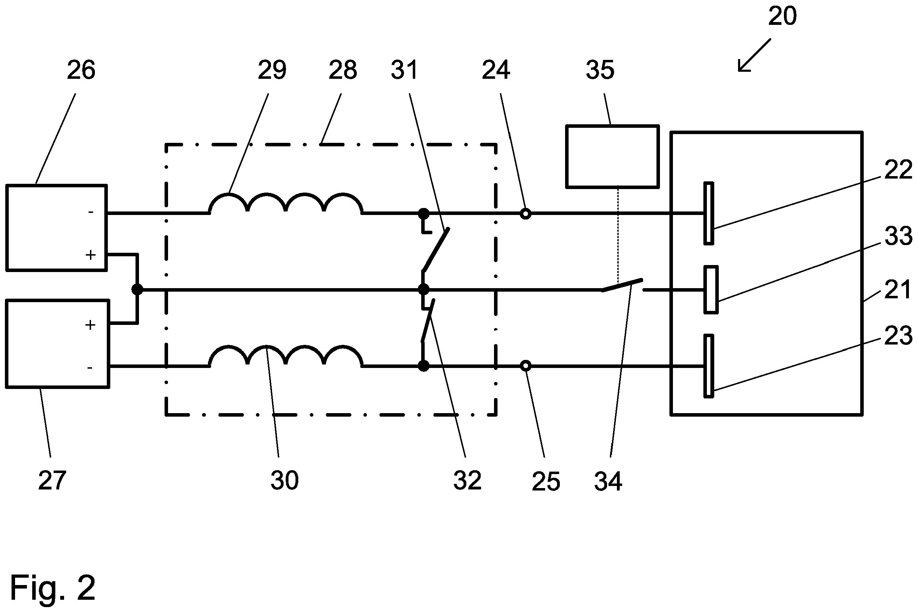

In Fig. 2 ist eine alternative erfindungsgemäße Vorrichtung 20 schematisch dargestellt die ebenfalls zum Ausführen des erfindungsgemäßen Verfahrens geeignet ist. Vorrichtung 20 umfasst eine Vakuumkammer 21, in der sich eine Doppelmagnetron-Einrichtung befindet, die zwei elektrisch voneinander isolierte Targets 22 und 23 aufweist. Mittels dieser Doppelmagnetron-Einrichtung kann ebenfalls wie mit Vorrichtung 10 aus Fig. 1 innerhalb der Vakuumkammer 21 auf einem Substrat eine Schicht mittels eines PVD- oder PECVD-Prozesses abgeschieden werden. Die beiden Targets 22, 23 sind elektrisch jeweils mit einem Pol einer Stromversorgungseinrichtung verbunden, die an den Klemmen 24 und 25 eine gepulste Wechselspannung zwischen den beiden Targets 22, 23 erzeugt.

Die Stromversorgungseinrichtung aus Fig. 2 umfasst zwei DC-Stromerzeuger 26 und 27, sowie einen Pulsgenerator 28. Die beiden DC-Stromerzeuger 26, 27 sind an den Pluspolen miteinander verbunden und stellen zeitlich konstante, jedoch separat voneinander einstellbare elektrische Leistungen zur Verfügung. Der Pulsgenerator umfasst zwei Induktivitäten 29 und 30 sowie zwei Schalter 31 und 32, die wechselseitig geöffnet bzw. geschlossen sind. Beim Umschalten wird immer erst der Schalter, der momentan geöffnet ist, geschlossen und anschließend der Schalter, der geschlossen war, geöffnet. Auf diese Weise ergibt sich beim Umschalten immer eine kurze Zeitphase, innerhalb der beide Schalter geschlossen sind. Auf diese Zeitphase wird später noch näher eingegangen.

Bei geöffnetem Schalter 31 und geschlossenem Schalter 32 ist das Target 22 über die Induktivität 29 mit dem Minuspol und das Target 23 mit dem Pluspol von Stromerzeuger 26 verbunden. Somit stellt bei dieser Konstellation der Stromversorger 26 Energie für eine Magnetronentladung zwischen den beiden Targets 22, 23 zur Verfügung, während in dieser Zeit die Energie des Stromerzeugers 27 in der Spule 30 gespeichert wird. Target 22 fungiert somit in diesen Zeitphasen als Katode und Target 23 als Anode der Magnetronentladung.

Beim Polwechsel wird zunächst der Schalter 31 geschlossen und anschließend der Schalter 32 geöffnet. Nun wird die in Spule 30 gespeicherte und die vom Stromerzeuger 27 bereitgestellte Energie ins Magnetronplasma gespeist, wobei jetzt das Target 23 als Katode und das Target 22 als Anode wirken, weil das Target 23 bei dieser Konstellation die Induktivität 30 mit dem Minuspol und das Target 22 mit dem Pluspol des Stromerzeugers 27 verbunden sind. Die Energie des Stromerzeugers 26 wird in dieser Phase in der Spule 29 gespeichert. Durch dieses wechselweise Schließen bzw. Öffnen der Schalter 31 und 31 wird an den Klemmen 24 und 25 eine für das bipolare gepulste Magnetronsputtern gebräuchliche gepulste Wechselspannung bereitgestellt. Die Frequenz der Umschaltung beträgt im Ausführungsbeispiel 50 kHz. Sie kann jedoch auch auf jede beliebige für das bipolar gepulste Magnetronsputtern übliche Frequenz eingestellt werden.

Erfindungsgemäß befindet sich noch eine zusätzliche Elektrode 33 in der Vakuumkammer 21, die über einen Schalter 34 mit beiden Pluspolen der Stromerzeuger 26, 27 verbunden werden kann. Bei geschlossenem Schalter 34 fungiert die zusätzliche Elektrode 33 als zusätzliche Anode einer Magnetronentladung, unabhängig davon, welches der beiden Targets 22, 23 gerade als Katode fungiert. Wird der Schalter 34 zu einer Zeit geschlossen, zu der das Target 22 als Katode fungiert, dann bildet sich sowohl eine Magnetronentladung zwischen den beiden Targets als auch zwischen dem Target 22 und der zusätzlichen Elektrode 33 aus. Wechselt in der Zeitspanne, in welcher der Schalter 34 geschlossen ist, die Polarität der Targets, so dass nun das Target 23 die Kathode darstellt, dann bildet sich sowohl eine Magnetronentladung zwischen den beiden Targets als auch zwischen dem Target 23 und der zusätzlichen Elektrode 33 aus. Hierbei ist anzumerken, dass der Hauptteil der Energie jeweils über die Magnetronentladung fließt, an der die zusätzliche Elektrode 33 als Anode beteiligt ist. Je nach Anordnung der Elektrode können bei einer erfindungsgemäßen Vorrichtung bis zu 95 % des Entladungsstromes über die zusätzliche Elektrode fließen.

Das Ansteuern des Schalters 34 erfolgt mittels einer Steuereinrichtung, mit der der Schalter 34 im Ausführungsbeispiel mit einer Frequenz von 2 kHz periodisch betätigt wird. Dabei kann das Tastverhältnis (also der Zeitanteil, innerhalb dem der Schalter 34 geschlossen ist) zwischen 0 % und 100 % eingestellt werden. Vorzugsweise wird das Betätigen des Schalters derart mit dem Polwechsel an den Klemmen 24, 25 synchronisiert, dass der Schalter 34 genau in dem Moment betätigt wird, wenn die beiden Schalter 31, 32 gerade beim Polaritätswechsel geschlossen sind. In diesen Momenten sinkt die Spannung zwischen den Klemmen 24, 25 nahezu auf 0 V, so dass der Schaltvorgang des Schalters 34 nicht unter einer elektrischen Last vollzogen werden muss. Die Anforderungen hinsichtlich der Spannungsfestigkeit des Schalters 34 sind dann nicht so hoch.

Messungen am Versuchsaufbau zeigten, dass beim Zuschalten der zusätzlichen Elektrode 33 als Anode aufgrund der besseren Erreichbarkeit für die Elektronen ca. 90 % des Entladungsstroms über die Zusatzelektrode 33 fließt. Ist der Schalter 34 geöffnet, fließt zwangsläufig der gesamte Anodenstrom über das als Anode geschaltete Target. Durch Einstellung des Tastverhältnisses der Anodenzuschaltung der zusätzlichen Elektrode lässt sich damit im zeitlichen Mittel der Anteil des über die Zusatzelektrode fließenden Entladungsstromes in einem weiten Bereich einstellen. Somit lassen sich auch Plasmaparameter und insbesondere die Stromdichte der auf die Oberfläche eines zu beschichtenden Substrates auftreffenden Teilchen in einem weiten Bereich zwischen der Teilchenstromdichte des unipolaren und der Teilchenstromdichte des bipolaren Betriebes einstellen.

Im Ausführungsbeispiel wurde die Vorrichtung 20 für ein Verfahren zum Abscheiden von Aluminiumnitrid-Schichten genutzt. Dazu wurde Aluminium als Targetmaterial auf beiden Targets 22, 23 des Doppelringmagnetrons eingesetzt. Unter Doppelringmagnetron ist ein Magnetron mit zwei elektrisch voneinander isolierten ringförmigen Targets zu verstehen, bei dem ein kleineres ringförmiges Target in der Ringöffnung eines größeren ringförmigen Targets angeordnet ist. Als Prozessgase wurden noch Argon mit einem Fluss von 40 sccm und Stickstoff mit einem Fluss von 20 sccm in die Vakuumkammer 21 eingelassen. Mit dem Stromerzeuger 26 wurde eine Leistung von 2 kW und mit dem Stromerzeuger 27 eine Leistung von 0,5 kW eingespeist. Zum Nachweis des Einflusses des erfindungsgemäßen Zuschaltens der Zusatzelektrode 33 als Anode auf den Beschuss der aufwachsenden Schicht mit energiereichen Teilchen wurden Messungen der Plasmadichte, des Ionenstromes sowie der Elektronentemperatur vor der Oberfläche eines in Vakuumkammer 21 zu beschichtenden Substrates durchgeführt.

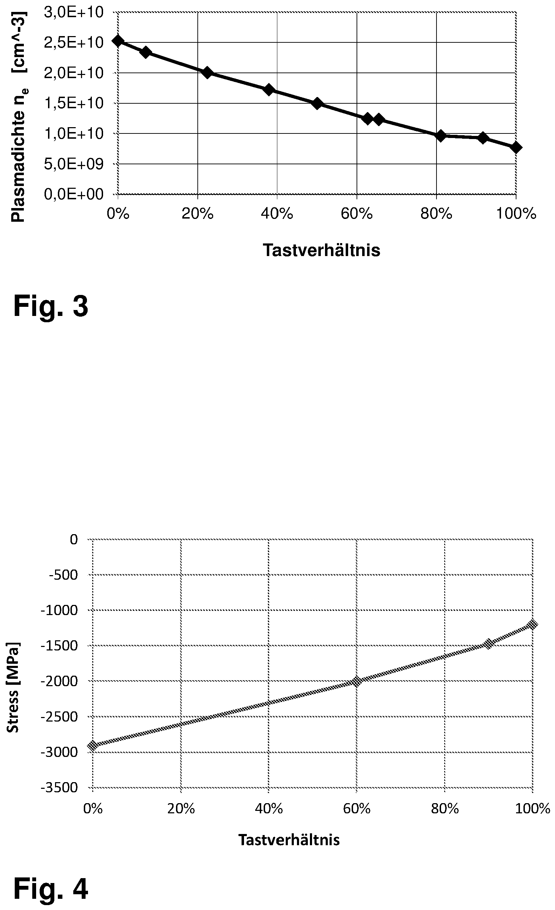

In Fig. 3 ist die Abhängigkeit der Plasmadichte vom Tastverhältnis graphisch dargestellt. Das Tastverhältnis 0 % entspricht dem herkömmlichen bipolaren Betrieb mit einer sehr hohen Plasmadichte vor dem Substrat. Das Tastverhältnis 100 % kommt dem herkömmlichen unipolaren Betrieb mit einer deutlich geringeren Plasmadichte sehr nahe. Wie aus Fig. 3 ersichtlich ist, lässt sich durch eine Veränderung des Tastverhältnisses die Plasmadichte mit erfindungsgemäßen Vorrichtungen und Verfahren stufenlos zwischen diesen beiden Extremwerten einstellen.

Ein Nachweis des Einflusses auf Eigenschaften der abgeschiedenen Aluminiumnitrid-Schichten erfolgte anhand des Messens von mechanischen Spannungen bei auf einem Substrat abgeschiedenen Schichten. Ergebnisse dieser Messungen sind in Fig. 4 graphisch dargestellt. Daraus ist ersichtlich, dass sich bei einem Tastverhältnis 0 % und einem daraus resultierenden intensiven energetischen Substratbeschuss hohe Druckspannungen bei den abgeschiedenen Schichten ergaben, die sich durch das Vergrößern des Tastverhältnisses reduzieren ließen.

## Patentansprüche

1. Magnetron-Vorrichtung, umfassend mindestens ein erstes Target (12) und ein zweites Target (13), welche elektrisch isoliert voneinander sind und welche sich innerhalb einer Vakuumkammer (11) befinden, mindestens eine Stromversorgungseinrichtung (14) zum Erzeugen einer elektrischen Wechselspannung, die zwischen die mindestens zwei voneinander elektrisch isolierten Targets (12; 13) schaltbar ist, so dass die beiden Targets (12; 13) abwechselnd als Katode und Anode einer Magnetronentladung zwischen den beiden Targets (12; 13) geschaltet sind, wobei mindestens eine zusätzliche, sich innerhalb der Vakuumkammer (11) befindende, Elektrode (15), die über einen Schalter (16) elektrisch an den Pol der Stromversorgungseinrichtung (14) angeschlossen ist, mit dem auch das erste Target (12) über einen weiteren Schalter (17) elektrisch verbunden ist, wobei mittels des Schalters (16) die mindestens eine zusätzliche Elektrode (15) zeitweise und wiederholt als Anode einer Magnetronentladung zwischen der zusätzlichen Elektrode (15) und dem als Katode fungierenden zweiten Target (13) schaltbar ist, **dadurch gekennzeichnet, dass**
- im Schaltzustand, wenn der Schalter (16) geöffnet ist, keine elektrisch leitfähige Verbindung zwischen der Stromversorgungseinrichtung (14) und der zusätzlichen Elektrode (15) ausgebildet ist;
- der Schalter (16) und der weitere Schalter (17) separat voneinander schaltbar sind.

2. Vorrichtung nach Anspruch 1, **dadurch gekennzeichnet, dass** eine zusätzliche Elektrode (15) nur einem als Katode fungierenden Target (13) zugeordnet ist.

3. Vorrichtung nach Anspruch 2, **dadurch gekennzeichnet, dass** jedem als Katode fungierenden Target eine separate zusätzliche Elektrode zugeordnet ist.

4. Vorrichtung nach Anspruch 1, **dadurch gekennzeichnet, dass** eine zusätzliche Elektrode (33) abwechselnd und nacheinander mehreren als Katode fungierenden Targets (22; 23) zugeordnet ist.

5. Vorrichtung nach einem der vorhergehenden Ansprüche, **dadurch gekennzeichnet, dass** die beiden Targets periodisch mit einer ersten Frequenz abwechselnd als Katode und Anode der Magnetronentladung zwischen den beiden Targets schaltbar sind.

6. Vorrichtung nach einem der vorhergehenden Ansprüche, **dadurch gekennzeichnet, dass** die zusätzliche Elektrode periodisch mit einer zweiten Frequenz als Anode einer Magnetronentladung zwischen der zusätzlichen Elektrode und dem als Katode fungierenden Target schaltbar ist.

7. Vorrichtung nach Anspruch 6, **dadurch gekennzeichnet, dass** die erste Frequenz größer ist als die zweite Frequenz.

8. Vorrichtung nach einem der vorhergehenden Ansprüche, **dadurch gekennzeichnet, dass** der Schalter, über den die mindestens eine zusätzliche Elektrode an einen Pol der Stromversorgungseinrichtung angeschlossen ist, derart konfiguriert ist, dass der Anteil der Zeit, innerhalb der die zusätzliche Elektrode als Anode geschaltet ist, in einem Bereich größer 0 % und kleiner 100 % einstellbar und während des Betriebes der Vorrichtung innerhalb dieses Bereichs veränderbar ist.

9. Verfahren zum gepulsten Betreiben einer Magnetron-Vorrichtung nach Anspruch 1, bei dem mittels mindestens einer Stromversorgungseinrichtung (14) eine Wechselspannung zwischen mindestens einem ersten Target (12) und einem zweiten Target (13) geschaltet wird, wobei die beiden Targets elektrisch isoliert voneinander sind, so dass die beiden, sich innerhalb einer Vakuumkammer (11) befindenden, Targets (12; 13) abwechselnd als Katode und Anode einer Magnetronentladung zwischen den beiden Targets (12; 13) fungieren, wobei mittels eines Schalters (16) mindestens eine sich innerhalb der Vakuumkammer (11) befindende zusätzliche Elektrode (15), die über den Schalter (16) an den Pol der Stromversorgungseinrichtung (14) angeschlossen wird, mit dem auch das erste Target (12) über einen weiteren Schalter (17) elektrisch verbunden wird, zeitweise und wiederholt als Anode einer Magnetronentladung zwischen der zusätzlichen Elektrode (15) und dem als Katode fungierenden zweiten Target (13) geschaltet wird, **dadurch gekennzeichnet, dass**
- im Schaltzustand, wenn der Schalter (16) geöffnet ist, keine elektrisch leitfähige Verbindung zwischen der Stromversorgungseinrichtung (14) und der zusätzlichen Elektrode (15) ausgebildet wird;
- der Schalter (16) und der weitere Schalter (17) separat voneinander geschaltet werden.

10. Verfahren nach Anspruch 9, **dadurch gekennzeichnet, dass** das abwechselnde Schalten der beiden Targets als Katode und Anode periodisch mit einer ersten Frequenz und das wiedeholte Schalten der zusätzlichen Elektrode als Anode periodisch mit einer zweiten Frequenz durchgeführt werden.

11. Verfahren nach Anspruch 10, **dadurch gekennzeichnet, dass** die zweite Frequenz kleiner als die erste Frequenz eingestellt wird.

12. Verfahren nach Anspruch 11, **dadurch gekennzeichnet, dass** das Betätigen des Schalters genau zu einem Zeitpunkt vorgenommen wird, an dem der Katoden- und Anodenwechsel an den Targets erfolgt.

13. Verfahren nach einem der Ansprüche 10 bis 12, **dadurch gekennzeichnet, dass** die Plasmadichte innerhalb der Vakuumkammer (11) verändert wird, indem die Zeitdauer, für die die zusätzliche Elektrode als Anode geschaltet wird, und/oder die zweite Frequenz während des Magnetronbetriebs verändert wird.

14. Verfahren nach einem der Ansprüche 9 bis 13, **dadurch gekennzeichnet, dass** dieses für das Beschichten mindestens eines Substrates innerhalb der Vakuumkammer mittels eines PVD- oder mittels eines plasmaunterstützten CVD-Prozesses verwendet wird.

## Claims

1. Magnetron apparatus, comprising at least one first target (12) and a second target (13), which are electrically insulated from one another and which are situated within a vacuum chamber (11), at least one power supply device (14) for generating an electrical AC voltage, which is switchable between the at least two targets (12; 13) that are electrically insulated from one another, such that the two targets (12; 13) are switched alternately as cathode and anode of a magnetron discharge between the two targets (12; 13), wherein at least one additional electrode (15) situated within the vacuum chamber (11) is electrically connected via a switch (16) to that pole of the power supply device (14) to which the first target (12) is also electrically connected via a further switch (17), wherein, by means of the switch (16), the at least one additional electrode (15) is switchable temporarily and repeatedly as anode of a magnetron discharge between the additional electrode (15) and the second target (13) functioning as cathode, **characterized in that**
- no electrically conductive connection between the power supply device (14) and the additional electrode (15) is formed in the switching state when the switch (16) is open;
- the switch (16) and the further switch (17) are switchable independently from one another.

2. Apparatus according to Claim 1, **characterized in that** an additional electrode (15) is assigned only to a target (13) functioning as cathode.

3. Apparatus according to Claim 2, **characterized in that** a separate additional electrode is assigned to each target functioning as cathode.

4. Apparatus according to Claim 1, **characterized in that** an additional electrode (33) is assigned alternately and successively to a plurality of targets (22; 23) functioning as cathode.

5. Apparatus according to any of the preceding claims, **characterized in that** the two targets are switchable periodically with a first frequency alternately as cathode and anode of the magnetron discharge between the two targets.

6. Apparatus according to any of the preceding claims, **characterized in that** the additional electrode is switchable periodically with a second frequency as anode of a magnetron discharge between the additional electrode and the target functioning as cathode.

7. Apparatus according to Claim 6, **characterized in that** the first frequency is greater than the second frequency.

8. Apparatus according to any of the preceding claims, **characterized in that** the switch via which the at least one additional electrode is connected to a pole of the power supply device is configured in such a way that the proportion of the time within which the additional electrode is switched as anode is settable in a range of greater than 0% and less than 100% and is variable within this range during the operation of the apparatus.

9. Method for pulsed operation of a magnetron apparatus according to Claim 1, wherein, by means of at least one power supply device (14), an AC voltage is switched between at least one first target (12) and a second target (13), wherein the two targets are electrically insulated from one another, such that the two targets (12; 13) situated within a vacuum chamber (11) function alternately as cathode and anode of a magnetron discharge between the two targets (12; 13), wherein, by means of a switch (16), at least one additional electrode (15) situated within the vacuum chamber (11) is connected via the switch (16) to that pole of the power supply device (14) to which the first target (12) is also electrically connected via a further switch (17), is switched temporarily and repeatedly as anode of a magnetron discharge between the additional electrode (15) and the second target (13) functioning as cathode, **characterized in that**
- no electrically conductive connection between the power supply device (14) and the additional electrode (15) is formed in the switching state when the switch (16) is open;
- the switch (16) and the further switch (17) are switched separately from one another.

10. Method according to Claim 9, **characterized in that** the alternate switching of the two targets as cathode and anode is carried out periodically with a first frequency and the repeated switching of the additional electrode as anode is carried out periodically with a second frequency.

11. Method according to Claim 10, **characterized in that** the second frequency is set to be less than the first frequency.

12. Method according to Claim 11, **characterized in that** the actuation of the switch is performed exactly at a point in time at which the cathode and anode change at the targets is performed.

13. Method according to any of Claims 10 to 12, **characterized in that** the plasma density within the vacuum chamber (11) during magnetron operation is varied by the time duration for which the additional electrode is switched as anode and/or by the second frequency being varied.

14. Method according to any of Claims 9 to 13, **characterized in that** said method is used for coating at least one substrate within the vacuum chamber by means of a PVD process or by means of a plasma-enhanced CVD process.

## Revendications

1. Arrangement de magnétron, comprenant au moins une première cible (12) et une deuxième cible (13) qui sont isolées électriquement l'une de l'autre et qui se trouvent à l'intérieur d'une chambre sous vide (11), au moins un dispositif d'alimentation électrique (14) destiné à générer une tension alternative électrique, qui peut être commutée entre les au moins deux cibles (12 ; 13) isolées électriquement l'une de l'autre, de sorte que les deux cibles (12 ; 13) sont commutées en alternance en tant que cathode et en tant qu'anode d'une décharge de magnétron entre les deux cibles (12 ; 13), dans lequel au moins une électrode supplémentaire (15), qui se trouve à l'intérieur d'une chambre sous vide (11) et qui est raccordée électriquement par le biais d'un commutateur (16) au pôle du dispositif d'alimentation électrique (14) auquel est également reliée électriquement la première cible (12) par le biais d'un commutateur supplémentaire (17), l'au moins une électrode supplémentaire (15) pouvant être commutée au moyen du commutateur (16) temporairement et de manière répétitive en tant qu'anode d'une décharge de magnétron entre l'électrode supplémentaire (15) et la deuxième cible (13) qui fait office de cathode, **caractérisé en ce que**
- dans l'état de commutation lorsque le commutateur (16) est ouvert, aucune liaison électriquement conductrice n'est formée entre le dispositif d'alimentation électrique (14) et l'électrode supplémentaire (15) ;
- le commutateur (16) et le commutateur supplémentaire (17) peuvent être commutés séparément l'un de l'autre.

2. Arrangement selon la revendication 1, **caractérisé en ce qu'**une électrode supplémentaire (15) est seulement associée à une cible (13) qui fait office de cathode.

3. Arrangement selon la revendication 2, **caractérisé en ce qu'**une électrode supplémentaire séparée est associée à chaque cible qui fait office de cathode.

4. Arrangement selon la revendication 1, **caractérisé en ce qu'**une électrode supplémentaire (33) est associée en alternance et successivement à plusieurs cibles (22 ; 23) qui font office de cathodes.

5. Arrangement selon l'une des revendications précédentes, **caractérisé en ce que** les deux cibles peuvent être commutées périodiquement avec une première fréquence en alternance en tant que cathode et qu'anode de la décharge de magnétron.

6. Arrangement selon l'une des revendications précédentes, **caractérisé en ce que** l'électrode supplémentaire peut être commutée périodiquement avec une deuxième fréquence en tant qu'anode d'une décharge de magnétron entre l'électrode supplémentaire et la cible qui fait office de cathode.

7. Arrangement selon la revendication 6, **caractérisé en ce que** la première fréquence est supérieure à la deuxième fréquence.

8. Arrangement selon l'une des revendications précédentes, **caractérisé en ce que** le commutateur par le biais duquel l'au moins une électrode supplémentaire est raccordée à un pôle du dispositif d'alimentation électrique est configuré de telle sorte que la part de temps pendant laquelle l'électrode supplémentaire est commutée en tant qu'anode est réglable dans une plage de plus de 0 % à moins de 100 % et elle est modifiable au sein de cette plage pendant le fonctionnement de l'arrangement.

9. Procédé de fonctionnement puisé d'un arrangement de magnétron selon la revendication 1, avec lequel une tension alternative est commutée entre au moins une première cible (12) et une deuxième cible (13) au moyen d'au moins un dispositif d'alimentation électrique (14), les deux cibles étant isolées électriquement l'une de l'autre, de sorte que les deux cibles (12 ; 13) qui se trouvent à l'intérieur d'une chambre sous vide (11) font office en alternance de cathode et d'anode d'une décharge de magnétron entre les deux cibles (12 ; 13), au moins une électrode supplémentaire (15) qui se trouve à l'intérieur d'une chambre sous vide (11) et qui est raccordée électriquement par le biais d'un commutateur (16) au pôle du dispositif d'alimentation électrique (14) auquel est également reliée électriquement la première cible (12) par le biais d'un commutateur supplémentaire (17), étant commutée au moyen du commutateur (16) temporairement et de manière répétitive en tant qu'anode d'une décharge de magnétron entre l'électrode supplémentaire (15) et la deuxième cible (13) qui fait office de cathode, **caractérisé en ce que**
- dans l'état de commutation lorsque le commutateur (16) est ouvert, aucune liaison électriquement conductrice n'est formée entre le dispositif d'alimentation électrique (14) et l'électrode supplémentaire (15) ;
- le commutateur (16) et le commutateur supplémentaire (17) sont commutés séparément l'un de l'autre.

10. Procédé selon la revendication 9, **caractérisé en ce que** la commutation en alternance des deux cibles en tant que cathode et qu'anode est effectuée périodiquement avec une première fréquence et la commutation répétée de l'électrode supplémentaire en tant qu'anode est effectuée périodiquement avec une deuxième fréquence.

11. Procédé selon la revendication 10, **caractérisé en ce que** la deuxième fréquence est inférieure à la première fréquence.

12. Procédé selon la revendication 11, **caractérisé en ce que** l'actionnement du commutateur est effectué exactement à l'instant auquel a lieu le changement de cathode et d'anode au niveau des cibles.

13. Procédé selon l'une des revendications 10 à 12, **caractérisé en ce que** la densité de plasma à l'intérieur de la chambre sous vide (11) est modifiée en modifiant la durée pendant laquelle l'électrode supplémentaire est commutée en tant qu'anode et/ou la deuxième fréquence pendant le fonctionnement du magnétron.

14. Procédé selon l'une des revendications 9 à 13, **caractérisé en ce que** celui-ci est utilisé pour l'enduction d'au moins un substrat à l'intérieur de la chambre sous vide au moyen d'un processus de dépôt physique en phase vapeur ou de dépôt chimique en phase vapeur assisté par plasma.
